# EUROPEAN PATENT APPLICATION

(11) **EP 4 492 928 A1**
(43) Date of publication of application: **15.01.2025**
(21) Application number: 24187325.6
(22) Date of filing: 09.07.2024
(51) Int. Cl.: H05K 3/34, H05K 1/02, H05K 3/00, H01R 12/62, H01R 13/6471, H05K 1/11, H05K 3/28

(54) **CABLE ASSEMBLY**

(30) Priority: 12.07.2023 US 202318221157
(62) Divisional of application: 24187601.0
(71) Applicant: Yamaichi Electronics Co., Ltd., Tokyo 144-8581 (JP); Japan Aviation Electronics Industry, Limited, Tokyo 150-0043 (JP)
(72) Inventor: ITO, Toshiyasu, Tokyo, 1448581 (JP); SHIMIZU, Osamu, Tokyo, 1448581 (JP); KUROKI, Yoshihide, Tokyo, 150-0043 (JP); NOZAWA, Keita, Tokyo, 150-0043 (JP); TANAKA, Masashi, Tokyo, 150-0043 (JP); KURIBAYASHI, Hiroaki, Tokyo, 150-0043 (JP)
(74) Representative: Nex & Phister Law & IP Aps

(57) **Abstract**

According to an embodiment, a cable assembly (40) arranged between a first connector (30) and a second connector (80) is disclosed. The first connector (30) is arranged at a position near a control device on a substrate (20) and the second connector (80) is arranged at a position away from the control device on the substrate (20). The cable assembly (40) includes a cable row (42), a paddle card substrate (41) and a hot melt material. In the cable row (42) a plurality of cables (2) each transmitting a differential signal are arranged side by side. The paddle card substrate (41) is provided with signal electrodes (4) and ground electrodes (5), internal conductors (21) of the plurality of cables (2) are electrically connected to the signal electrodes. External conductors (23) of the plurality of cables (2) are electrically connected to the ground electrodes (5). The hot melt material (440) is arranged on the paddle card substrate (41) so as to cover at least a solder joining portion (29) at a tip of an exposed portion of the internal conductor (21) and the exposed portion of the internal conductor (21).

## Description

### Technical Field

The present disclosure relates to high-speed signal transmission between an ASIC (application specific integrated circuit) and an optical transceiver, and particularly, relates to a cable assembly, and a high-speed transmission device combining them.

### Background of the Invention

As documents related to this type of technology, there are U.S. Patent publication 9011177B2 (Patent Document 1) and U.S. Patent publication 9203193B2 (Patent Document 2). In the high-speed interconnect cable assembly disclosed in Patent Document 1, a Twinax type by-pass cable is disposed between an ASIC and a terminal member of its peripheral edge portion on a circuit board, a connector member is connected to a terminal member, and a signal is transmitted to an external device via this connector member. In the electrical device disclosed in Patent Document 2, a by-pass cable on a circuit board is a communication cable including a differential pair of signal conductors, a shield layer enclosing the signal conductors, and a cable jacket surrounding the shield layer, an access opening portion for exposing a portion of the shield layer is provided in the cable jacket of the communication cable, and this access opening portion is electrically connected to a grounding contact on the substrate.

The signal transmission characteristics of this type of circuit board depend on the frequency of the signal and the transmission distance of the signal, and the higher the frequency of the signal is, the shorter the transmittable distance becomes. The standard transmitting/receiving rate and the transmission distance in the case of signal transmission on the substrate are 50 cm for 50 Gbps, 25 cm for 100 Gbps, and 12.5 cm for 200 Gbps.

Incidentally, the inventor of the present application is trying to develop a technology for performing high-speed signal transmission of 112 Gbps or more between an ASIC and an optical transceiver. However, since the technologies of Patent Documents 1 and 2 merely connect the ASIC on the substrate and an apparatus away from it with a cable, there were problems that when high-speed signal transmission of 112 Gbps or more is performed, the occurrence of crosstalk cannot be sufficiently prevented unless the distance between the apparatus is brought close to about 25 cm, and inconvenience occurs in the electrical characteristics, such as the impedance not being easy to be adjusted.

The present disclosure has been made in view of such problems, and one of the objects is to provide technical means capable of suppressing the occurrence of crosstalk when performing high-speed signal transmission between apparatus arranged at separated positions on a substrate, and making it easy to adjust impedance and obtaining good electrical characteristics.

### Summary of the invention

In accordance with a first aspect of the present disclosure, there is provided a cable assembly arranged between a first connector which is arranged at a position near a control device on a substrate and a second connector which is arranged at a position away from the control device on the substrate, including: a cable row in which a plurality of cables each transmitting a differential signal are arranged side by side; a paddle card substrate provided with signal electrodes to which internal conductors of the plurality of cables are electrically connected and ground electrodes to which external conductors of the plurality of cables are electrically connected; and a hot melt material arranged on the paddle card substrate so as to cover at least a solder joining portion at a tip of an exposed portion of the internal conductor and the exposed portion of the internal conductor.

In this aspect, a thickness of the hot melt of the solder joining portion at the tip of the exposed portion of the internal conductor is may be thinner than a thickness of the hot melt arranged at the exposed portion of the internal conductor.

Further, the cable assembly may further comprise a ground cover covering the internal conductor on the paddle card substrate, and the hot melt material may be arranged on the paddle card substrate so as to cover at least the exposed portion of the internal conductor inside the ground cover.

In addition, the hot melt material may be arranged on the paddle card substrate so as to cover at least the ground cover and at least the exposed portion of the internal conductor inside the ground cover.

Further, the ground covers may be arranged for every channel and arranged alternately with each other on front and back of the paddle card substrate.

Furthermore, the hot melt material may be arranged on the paddle card substrate so as to cover at least the ground cover and at least the exposed portion of the internal conductor inside the ground cover.

In accordance with a second aspect of the present disclosure, there is provided a cable assembly arranged between a first connector which is arranged at a position near a control device on a substrate and a second connector which is arranged at a position away from the control device on the substrate, including: a cable row in which a plurality of cables each transmitting a differential signal are arranged side by side; a paddle card substrate provided with signal electrodes to which internal conductors of the plurality of cables are electrically connected and ground electrodes to which external conductors of the plurality of cables are electrically connected; a plastic member arranged on the paddle card substrate and having an outer frame portion and a plurality of inner frame portions arranged side by side with slight gaps on an inner edge of the outer frame portion; ground covers arranged to cover part or all of the plurality of inner frame portions; and potting materials arranged within the inner frame portions so as to cover at least exposed portions of the internal conductors.

In this aspect, the ground covers may be arranged for every channel and arranged alternately with each other on front and back of the paddle card substrate.

In accordance with a third aspect of the present disclosure, there is provided a cable assembly arranged between a first connector which is arranged at a position near a control device on a substrate and a second connector which is arranged at a position away from the control device on the substrate, including: a cable row in which a plurality of cables each transmitting a differential signal are arranged side by side; and a paddle card substrate including signal electrodes to which internal conductors of the plurality of cables are electrically connected, and ground electrodes arranged at first positions where the external conductors of the cables are attached and at second positions coupled to contact portions with the first connector on both sides sandwiching the signal electrodes, wherein the ground electrodes to which the external conductors of the cables are attached are arranged at the first positions of the substrate thinner than the second position of the substrate where the signal electrodes are located.

In this aspect, the ground electrode may comprise a cable side contact portion in contact with the cable and a connector side contact portion in contact with the first connector, the cable side contact portion and the connector side contact portion may be connected through an inner layer wiring of the paddle card substrate.

Further, the cable assembly in this aspect may further comprise a hot melt material arranged on the paddle card substrate so as to cover at least a solder joining portion at a tip of an exposed portion of the internal conductor and the exposed portion of the internal conductor.

In addition, the cable assembly in this aspect may further comprise a hot melt material arranged on the paddle card substrate so as to cover at least a solder joining portion at a tip of an exposed portion of the internal conductor and the exposed portion of the internal conductor; and ground covers that cover the internal conductors on the paddle card substrate, and may be arranged for every channel and arranged alternately with each other on front and back of the paddle card substrate.

Further, the cable assembly in this aspect may further comprise ground covers arranged to cover the internal conductors on the ground electrodes arranged at positions coupled to the contact portions with the first connector on both sides sandwiching the signal electrodes.

Furthermore, the ground covers may cover the internal conductors on the paddle card substrate and may be arranged for every channel and alternately with each other on front and back of the paddle card substrate.

In accordance with a fourth aspect of the present disclosure, there is provided a method of manufacturing cable assembly, including: soldering a tip end of an exposed portion of an internal conductor onto a paddle card substrate; attaching a plastic member to the paddle card substrate, the plastic member having an outer frame portion and a plurality of inner frame portions arranged side by side with a slight gap on an inner edge of the outer frame portion; arranging a ground cover with a press-fit so as to cover part or all of the plurality of inner frame portions, and inserting and attaching it into a hole of the paddle card substrate; and injecting a potting material into the inner frame portion so as to cover an exposed portion of the internal conductor, and then hardening it.

### Brief description OF DRAWINGS

Fig. 1 is a side view of a high-speed transmission device 1 including an ASIC 10, a first connector 30, a cable assembly 40, and a second connector 80 according to the first embodiment of the present disclosure;
Fig. 2 is a perspective view of the cable assembly 40 according to the first embodiment of the present disclosure;
Fig. 3 is a perspective view of the cable assembly 40 without hot melt material 440;
Fig. 4 is a diagram of Fig. 2 viewed from a direction of arrow J;
Fig. 5 is a diagram showing an impedance waveform of the cable assembly 40 and an impedance waveform of the cable assembly 40 without hot melt material 440;
Fig. 6 is a diagram showing a cable assembly 40A according to a second embodiment of the present disclosure;
Fig. 7 is a diagram of Fig. 6 viewed from a direction of arrow J;
Fig. 8 is a diagram showing a cable assembly 40B according to a third embodiment of the present disclosure;
Fig. 9 is a diagram of Fig. 8 viewed from a direction of arrow J;
Fig. 10 is a diagram of the cable assembly 40B without hot melt material 440B;
Fig. 11 is an exploded view of Fig. 10;
Fig. 12 is a diagram of Fig. 10 viewed from a direction of arrow H;
Fig. 13 is a diagram showing a cable assembly 40C according to a fourth embodiment of the present disclosure;
Fig. 14 is an exploded view of Fig. 13;
Fig. 15 is a diagram of Fig. 13 viewed from a direction of arrow J;
Fig. 16 is a diagram of Fig. 13 viewed from a direction of arrow H;
Fig. 17 is a partial cross-sectional view of Fig. 15;
Fig. 18 is a diagram showing a first stage of a manufacturing process of the cable assembly 40C;
Fig. 19 is a diagram showing a second stage of the manufacturing process of the cable assembly 40C;
Fig. 20 is a diagram showing a third stage of the manufacturing processes of the cable assembly 40C;
Fig. 21 is a diagram showing a fourth stage of the manufacturing processes of the cable assembly 40C;
Fig. 22 is a diagram showing a comparison of FEXT when the ground cover 240 is brought into close contact with the ground electrode 5 of the paddle card substrate 41 at the stage of Fig. 20 and when the ground cover 240 is floated by 0.05mm;
Fig. 23 is a diagram showing an impedance waveform of the cable assembly 40C, and an impedance waveform of the cable assembly 40C without a potting material 541;
Fig. 24 is a plan view of the paddle card substrate 41 of the fifth embodiment of the present disclosure; and
Fig. 25 is a cross-sectional view of the fifth embodiment viewed from line A-A' of Fig. 24.

### Detailed Description of Embodiments

### <First Embodiment >

A high-speed transmission device 1 including a cable assembly 40, a first connector 30, and a second connector 80 according to the first embodiment of the present disclosure will be described. This high-speed transmission device 1 is mounted on a network switch or a server. The high-speed transmission device 1 includes: a rectangular substrate 20; an ASIC10 and an optical transceiver 90 disposed at positions separated by a predetermined distance (for example, 25 cm) on the substrate 20; a first connector 30, a cable assembly 40, and a second connector 80 disposed between the ASIC10 and the optical transceiver 90; and a cage 95 covering the optical transceiver 90 and the second connector 80. The optical transceiver 90 is mounted on the second connector 80 and performs high-speed differential transmission of 112 Gbps or more by PAM (Pulse Amplitude Modulation) with the ASIC10. In the present embodiment, differential signals of sixteen channels can be transmitted between the ASIC 10 and the optical transceiver 90.

In the following explanation, the direction where the ASIC10 and the optical transceiver 90 are separated on the substrate 20 is appropriately referred to as an X direction, one direction orthogonal to the X direction is appropriately referred to as an Y direction, and a direction orthogonal to both the X direction and the Y direction is appropriately referred to as a Z direction. In addition, when viewed from the optical transceiver 90 in the X direction, the -X side, which is the side where the ASIC 10 is located, may be referred to as a front side, and the opposite + X side may be referred to as a rear side. In addition, when viewed from the substrate 20 in the Z direction, the +Z side, which is the side where the ASIC10 and the optical transceiver 90 are located, may be referred to as an upper side, and the opposite -Z side may be referred to as a lower side. In addition, the +Y side when viewed from the rear side in the X direction may be referred to as a left side and the -Y side when viewed from the rear side may be referred to as a right side.

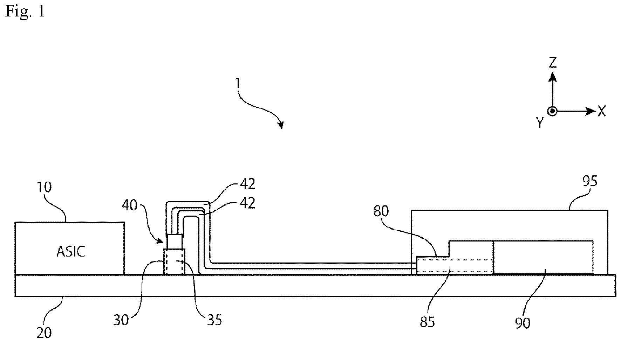

In Fig. 1, each pair of +terminal and -terminal of differential signals each corresponding to one channel and a ground terminal are exposed on the lower surface of the ASIC10. Each pair of +terminal and -terminal and the ground terminal of the ASIC10 are soldered to pads (not shown) of the substrate 20.

The first connector 30 is disposed at a position near the rear side of the ASIC10 on the substrate 20. The distance between the ASIC10 and the first connector 30 is, for example, 5cm.

In the first connector 30, a slot 35 is provided in an approximately rectangular parallelepiped shaped insulator so as to pass through its top and bottom, twenty five narrow grooves are provided on the front and rear wall surfaces within this slot 35, and contact pins are pressed into the twenty five narrow grooves.

Here, among the twenty five contact pins pressed into the front and rear wall surfaces within the slot 35 of the first connector 30, respectively, the contact pins at both the left and right ends, and every two contact pins arranged between them are contact pins for ground, and the contact pins sandwiched between the contact pins for ground are contact pins for differential signal. Hereinafter, the letter (G) is attached to the contact pin for ground and the letter (S) is attached to the contact pin for differential signal to distinguish between the two kinds of contact pins.

In Fig. 1, a wiring going backward from the fixed positions of the +terminal and -terminal of differential signals of the ASIC10 and the ground terminal on the substrate 20 is laid on the substrate 20, and the wiring is connected to the substrate side contact portions of the contact pins (G) and (S) of the first connector 30.

In the second connector 80, in an insulator having a shape in which one corner of a rectangular parallelepiped body is cut out a slot 85 passing through its front and rear is provided, twenty five narrow grooves are provided on the upper and lower wall surfaces within the slot 85, and the contact pins (G) and (S) are pressed into the twenty five narrow grooves.

The contact pins (G) and (S) of the second connector 80 are respectively connected to the rear end portion of the external conductor 23 and the rear end portion of the internal conductor 21 of the Twinax cable 2 via the ground electrode and the signal electrode on the connector substrate. The header of the optical transceiver 90 is fitted to the opening on the side opposite to the side of the Twinax cable 2 in the second connector 80, and the electrodes of the header of the optical transceiver 90 are electrically connected to the contact pins (G) and (S) of the second connector 80.

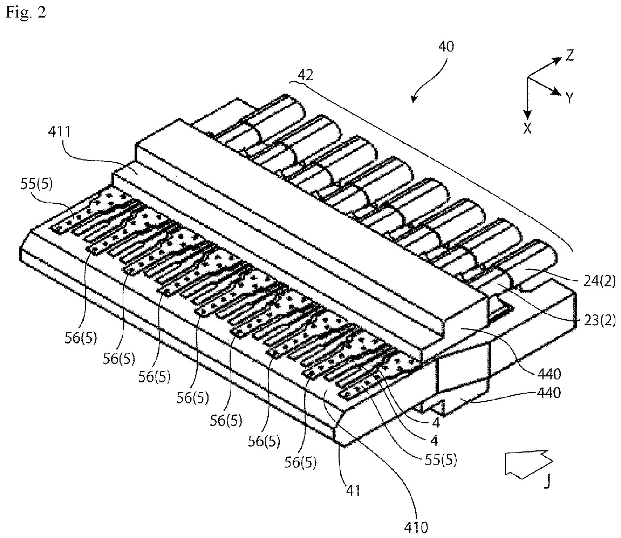

As shown in Fig. 2, Fig. 3, and Fig. 4, the cable assembly 40 has a cable row 42 in which eight Twinax cables 2 are arranged side by side on the left and right, a paddle card substrate 41 and hot melt materials 440.

The Twinax cable 2 has two internal conductors 21, a dielectric body 22, an external conductor 23, and a jacket 24. The two internal conductors 21 are arranged in parallel, and each of the internal conductors 21 is covered with the dielectric body 22. The external conductor 23 covers a bundle of two dielectric bodies 22, and the jacket 24 covers the external conductor 23.

The paddle card substrate 41 has a rectangular plate shape with approximately the same left-right width and thickness as those of the slot 35 of the first connector 30. The front and rear surface layers 410 of the paddle card substrate 41 are provided with signal electrodes 4 and ground electrodes 5.

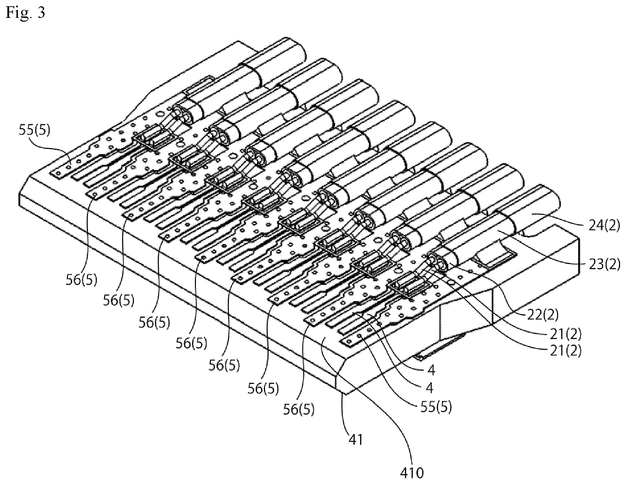

As shown in Fig. 3, the sixteen signal electrodes 4 on the front and rear surface layers 410 are paired by two. There are ground electrodes 5 at positions coupled to the contact portions with the first connector 30 on both sides sandwiching the signal electrodes 4 on the surface layer 410. The base portions of the ground electrodes 5 occupy approximately the entire surface on the upper side of the signal electrodes 4 on the surface layer 410, and two first extension portions 55 at both the left and right ends and seven second extension portions 56 between the two first extension portions 55 extend downward from the base portions 54. The pairs of the signal electrodes 4 and the second extension portions 56 are alternately arranged side by side at intervals on the inner side sandwiched by the left and right first extension portions 55 on the surface layer 410.

The lower ends of the first extension portion 55 and the second extension portion 56 reach the lower side with respect to the lower end of the signal electrode 4. The left-right widths of the first extension portion 55 and the second extension portion 56 become narrow on the way to reach the lower ends.

As shown in Fig. 2, the hot melt material 440 has a shape in which one corner of a rectangular parallelepiped body having a left-right width approximately the same as that of the paddle card substrate 41 and an upper-lower width slightly larger than that of the exposed portion of the internal conductor 21 of the Twinax cable 2 on the surface layer 410 is cut out. The cut-out portion of the hot melt material 440 forms a stepped portion 411. The hot melt material 440 is in contact with the first extension portions 55 and the second extension portions 56 of the ground electrodes 5 on the surface layer 410, and the exposed portions of the internal conductors 21 of the signal electrodes 4 and the solder joining portions 29 at the tips thereof, and covers them. The hot melt material 440 is formed by pouring a thermoplastic polymer into a mold arranged on the surface layer 410 of the paddle card substrate 41, cooling and solidifying it, and then removing the mold.

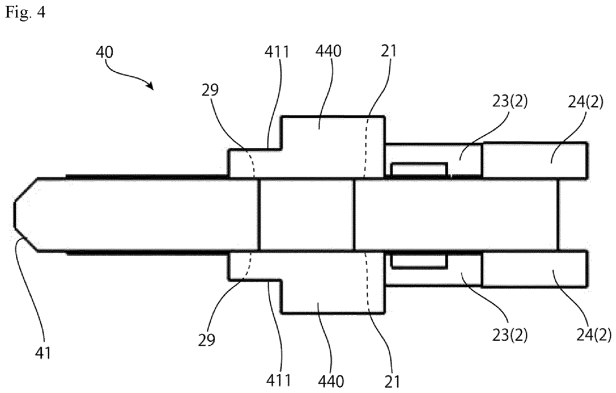

As shown in Fig. 4, the thickness of the stepped portion 411 of the hot melt material 440 is thinner than the thickness of the portion on its upper side. The thick portion on the upper side of the stepped portion 411 of the hot melt material 440 is arranged at the exposed portion of the internal conductor 21 on the paddle card substrate 41, and the stepped portion 411 is arranged at the solder joining portion 29 at the tip of the exposed portion of the internal conductor 21.

When the paddle card substrate 41 is inserted into the slot 35 of the first connector 30, the contact pins in the first connector 30 come into contact with the ground electrode 5 and the signal electrode 4 on the connector side of the paddle card substrate 41.

The details of the configuration of the present embodiment are described above. The cable assembly 40 according to the present embodiment is arranged between a first connector 30 arranged at the position near the ASIC10 which is a control device on the substrate 20, and a second connector 80 arranged at the position away from the control device on the substrate 20, and has: a cable row 42 in which a plurality of Twinax cables 2 each transmitting a differential signal are arranged side by side; a paddle card substrate 41 provided with signal electrodes 4 to which the internal conductors 21 of the plurality of Twinax cables 2 are electrically connected, and ground electrodes 5 to which the external conductors 23 of the plurality of Twinax cables 2 are electrically connected; and hot melt materials 440 arranged on the paddle card substrate 41 so as to cover at least the solder joining portions 29 at the tips of the exposed portions of the internal conductors 21 and the exposed portions of the internal conductors 21. Thus, it is possible to suppress an increase in impedance when high-speed signal transmission is performed between the ASIC10 and the optical transceiver 90 arranged at separated positions on the substrate 20. Normally, the solder joining portion 29 and the area of the air layer around the exposed portion of the internal conductor 21 have increased impedance, but the increase in impedance can be suppressed by the configuration of the present embodiment, so better signal transmission characteristics can be achieved.

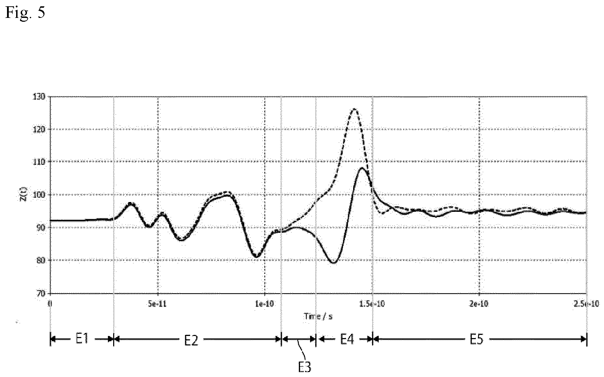

Here, the inventor of the present application performed the following verification to confirm the effect of the present disclosure. The inventor of the present disclosure calculated, by a TDR simulator, a TDR waveform in which the cable assembly 40 is used as a DUT, and a TDR waveform in which the cable assembly 40 without the hot melt material 440 is used as a DUT, respectively. Fig. 5 is a diagram showing this simulation result. The solid line in Fig. 5 is the TDR waveform of the cable assembly 40, and the dashed line is the TDR waveform of the cable assembly 40 without the hot melt material 440. In this waveform, section E1 corresponds to the propagation time of the signal of the substrate 20, section E2 corresponds to the propagation time of the signal of the first connector 30, section E3 corresponds to the propagation time of the signal of the solder joining portion 29, section E4 corresponds to the propagation time of the signal of the exposed portion of the internal conductor 21 of the Twinax cable 2, and section E5 corresponds to the propagation time of the signal within the Twinax cable 2.

Referring to Fig. 5, in the TDR waveform of the cable assembly 40 with the hot melt material 440 removed, the peak impedance in the section E3 has risen to 97 Ω, and the peak impedance in the section E4 has risen to 128 S2, while in the TDR waveform of the cable assembly 40, the peak impedance in the section E3 has declined to 87 Ω, and the peak impedance in the section E4 has declined to 108 Ω. As shown in Fig. 2 and Fig. 4, in the cable assembly 40, the exposed portion of the internal conductor 21 of the Twinax cable 2 and the solder joining portion 29 at the tip thereof are completely covered by the hot melt material 440, and this is considered that this contributes to the reduction of the peak impedance in the section E3 and the section E4. It is to be noted that by making the thickness of the stepped portion 411 of the hot melt material 440 arranged at the solder joining portion 29 thinner than the thickness of the portion on the upper side thereof, a drastic decrease in the impedance in the section E3 is prevented.

### <Second Embodiment >

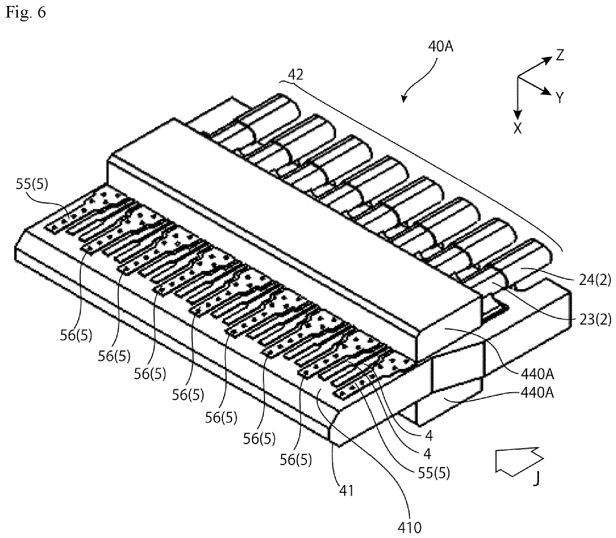

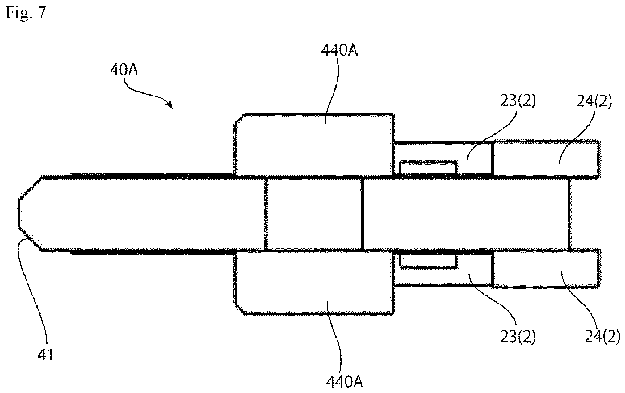

Next, the second embodiment of the present disclosure is described. Fig. 6 is a diagram showing a cable assembly 40A according to a second embodiment of the present disclosure. Fig. 7 is a diagram of Fig. 6 viewed from a direction of arrow J. In these figures, the same elements as those in the first embodiment are denoted by the same reference numerals, and a repeated description thereof is omitted.

In the present embodiment, the hot melt material 440 of the first embodiment is replaced by a hot melt material 440A. The hot melt material 440A has a rectangular parallelepiped shape having a left-right width approximately the same as that of the paddle card substrate 41 and an upper and lower width slightly larger than that of the exposed portion of the internal conductor 21 of the Twinax cable 2 on the surface layer 410. The hot melt material 440A is in contact with the first extension portions 55 and the second extension portions 56 of the ground electrodes 5 on the surface layer 410, the solder joining portion 29, the internal conductor 21, the dielectric 22 and the external conductor 23, and covers these elements. The hot melt material 440A is formed by pouring a thermoplastic polymer into a mold arranged on the surface layer 410 of the paddle card substrate 41, cooling and solidifying it, and then removing the mold.

The details of the configuration of the present embodiment are described above. According to the present embodiment, when the hot melt material 440A is removed, an effect similar to the first embodiment described above can be obtained when the impedance of the solder joining portion 29 and the exposed portion of the internal conductor 21 is almost the same.

### <Third embodiment >

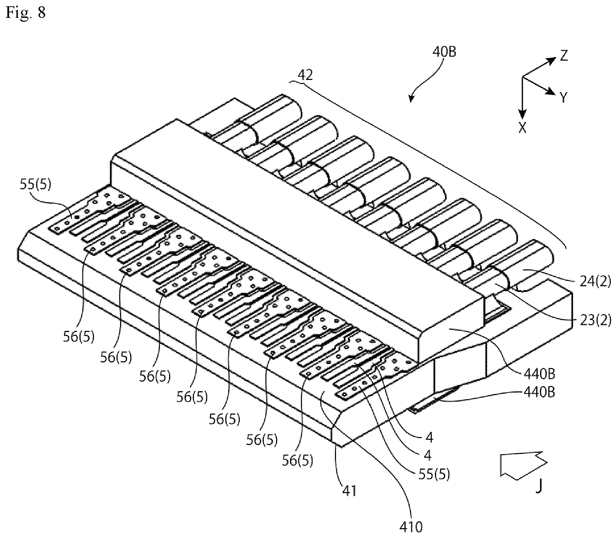

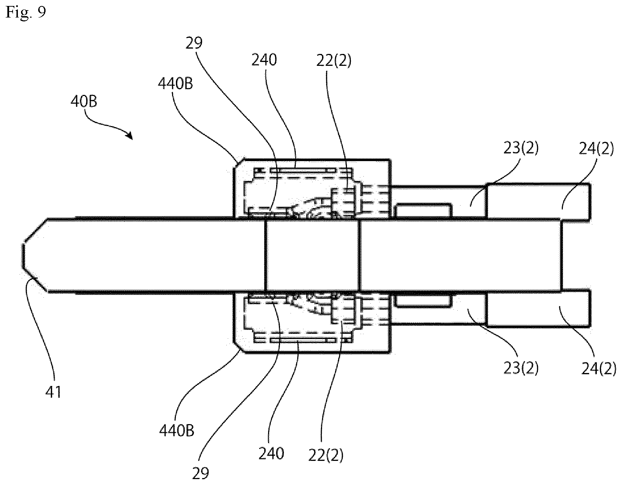

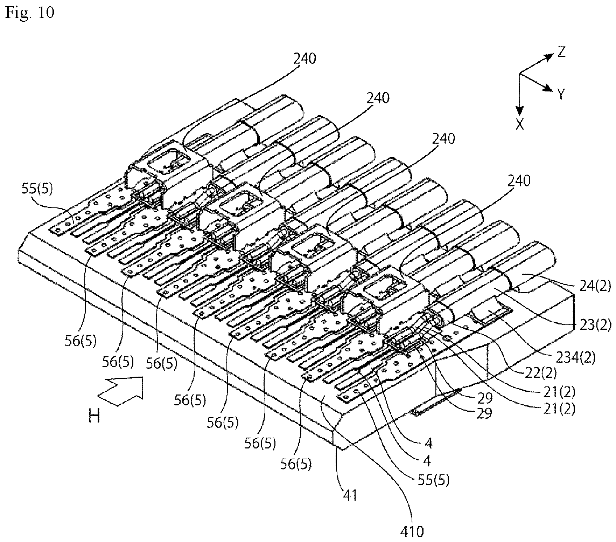

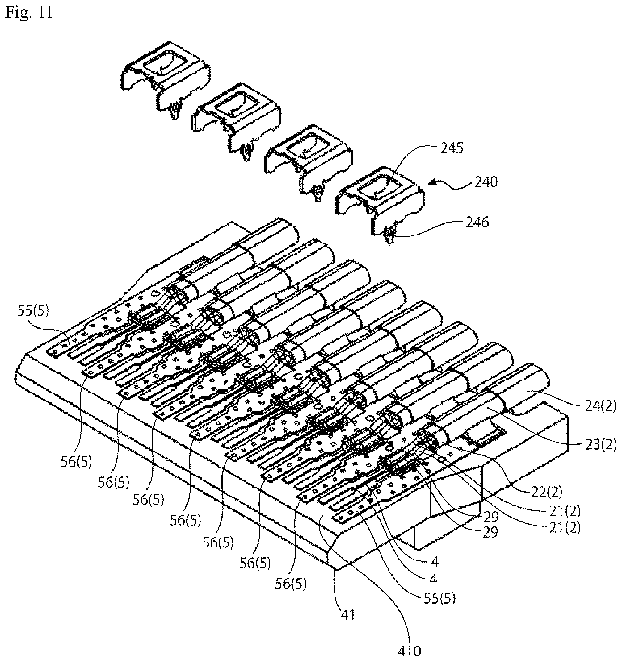

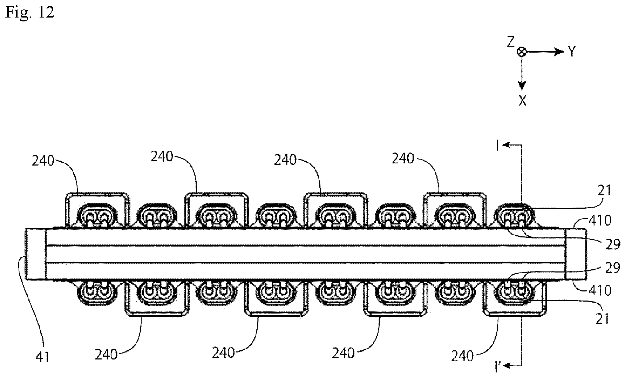

Next, the third embodiment of the present disclosure is described. Fig. 8 is a diagram showing a cable assembly 40B according to the third embodiment of the present disclosure. Fig. 9 is a diagram of Fig. 8 viewed from the direction of arrow J. Fig. 10 is a diagram of the cable assembly 40B without hot melt material 440B. Fig. 11 is an exploded view of Fig. 10. Fig. 12 is a diagram of Fig. 10 viewed from the direction of arrow H. In these figures, the same elements as those in the first to second embodiments are denoted by the same reference numerals, and a repeated description thereof is omitted.

In the present embodiment, the hot melt material 440 in the first embodiment is replaced by the hot melt material 440B and a ground cover 240.

The ground cover 240 is obtained by bending a metal plate having a rectangular opening 245 with portions on both sides of the opening 245 as ridge lines. A press-fit terminal 246 is provided at the end side of the bent tip of the ground cover 240.

As shown in Fig. 12, the ground covers 240 are arranged for every channel and arranged alternately with each other on the front and back of the paddle card substrate 41. There are four ground covers 240 on the -X side and +X side of the paddle card substrate 41, respectively. The four ground covers 240 on the -X side are fixed to the surface layer 410 on the -X side so as to cover the respective pairs of the internal conductors 21 and the solder joining portions 29 in the Twinax cables 2 of the first, third, fifth and seventh channels from the -Y side end on the -X side. The four ground covers 240 on the +X side are fixed to the surface layer 410 on the +X side so as to cover the respective pairs of the internal conductors 21 and the solder joining portions 29 in the Twinax cables 2 of the second, fourth, sixth and eighth channels from the -Y side end on the +X side. The press-fit terminals 246 of the ground covers 240 are inserted into the holes of the extension portions 55 and 56 of the ground electrodes 5.

The hot melt material 440B is in contact with the first extension portions 55 and the second extension portions 56 of the ground electrodes 5 on the surface layer 410, the solder joining portions 29, the exposed portions of the internal conductors 21 inside the ground cover 240, the dielectrics 22, the external conductors 23, and the ground covers 240, and covers these elements. The hot melt material 440 B is formed by pouring a thermoplastic polymer into a mold arranged on the surface layer 410 of the paddle card substrate 41, cooling and solidifying it, and then removing the mold.

The details of the configuration of the present embodiment are described above. The same effects as those of the above first to second embodiments are also obtained according to the present embodiment. Further, it is possible to prevent the occurrence of crosstalk and ensure good electrical characteristics.

### <Fourth embodiment >

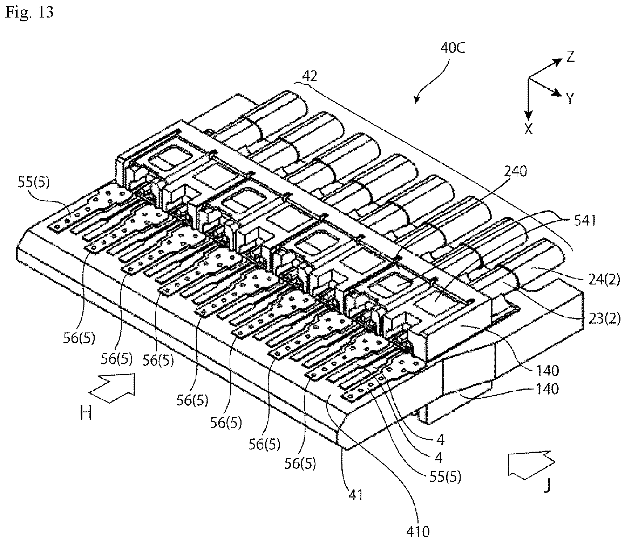

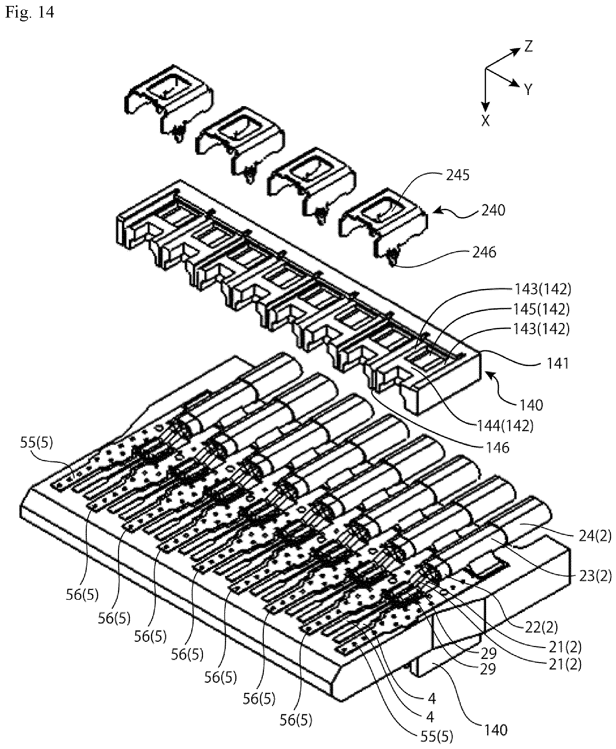

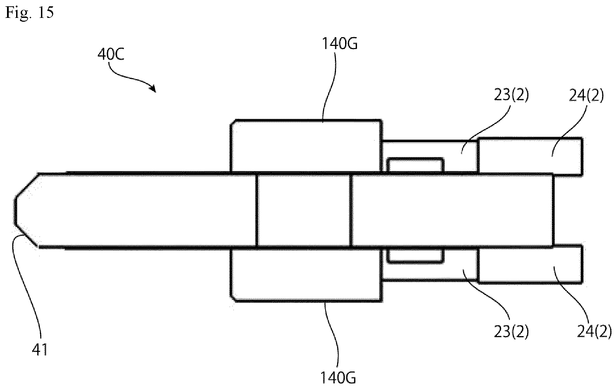

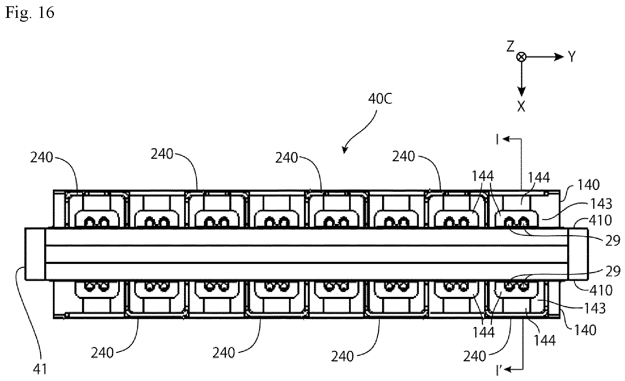

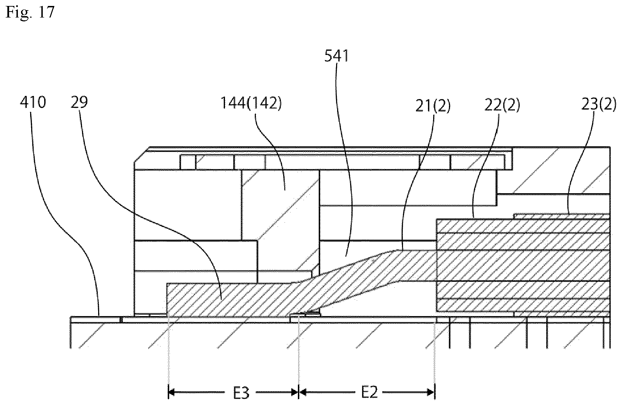

Next, the fourth embodiment of the present disclosure is described. Fig. 13 is a diagram showing a cable assembly 40C according to the fourth embodiment of the present disclosure. Fig. 14 is an exploded view of Fig. 13. Fig. 15 is a diagram of Fig. 13 viewed from the direction of arrow J. Fig. 16 is a diagram of Fig. 13 viewed from the direction of arrow H. Fig. 17 is a partial cross-sectional view of Fig. 15. In these figures, the same elements as those in the first to third embodiments are denoted by the same reference numerals, and a repeated description thereof is omitted.

In the present embodiment, the hot melt material 440 in the first embodiment has been replaced by a plastic member 140, ground covers 240, and potting materials 541.

As shown in Fig. 14, the plastic member 140 has an outer frame portion 141 and eight inner frame portions 142 arranged side by side with a slight gap 146 on the inner edge of the outer frame portion 141. The left-right width of the outer frame portion 141 is approximately the same as the left-right width of the paddle card substrate 41. The upper-lower width of the outer frame portion 141 is approximately the same as the upper-lower width of a portion of the paddle card substrate 41 from tip end of the solder joining portions 29 of the internal conductor 21 to a portion of the external conductor 23.

The inner frame portion 142 has two wall portions 143 on the left and right extending up and down, and a wall portion 144 connecting the middle portions of the two wall portions 143 in the up and down direction.

The surface on the -Z side of the outer frame portion 141 and the surface on the +Z side of the wall portion 144 are separated by a distance approximately the same as the upper-lower width of a portion of the Twinax cable 2 including the exposed portion of the internal conductor 21 and the exposed dielectric portion 22, and an opening 145 surrounded by the outer frame portion 141, the wall portions 143 on the left and right of the inner frame portion 142, and the wall portion 144 is formed.

In the present embodiment, the four ground covers 240 on the -X side are fixed to the surface layer 410 on the -X side so as to cover the first inner frame portion 142, the third inner frame portion 142, the fifth inner frame portion 142, and the seventh inner frame portion 142 from the -Y side end of the plastic member 140 on the -X side. The four ground covers 240 on the +X side are fixed to the surface layer 410 on the +X side so as to cover the second inner frame portion 142, the fourth inner frame portion 142, the sixth inner frame portion 142, and the eighth inner frame portions 142 from the -Y side end of the plastic member 140 on the +X side. The press-fit terminals 246 of the ground covers 240 are inserted into the holes of the extension portions 55 and 56 of the ground electrodes 5.

The potting material 541 is obtained by pouring epoxy resin into each inner frame portion 142 of the plastic member 140 and solidifying it. Urethane resin or silicone resin may be used instead of epoxy resin as the material for the potting material 541.

The potting material 541 is in contact with the internal conductor 21 and the dielectric 22 on the surface layer 410, and the plastic member 140, and covers the internal conductor 21.

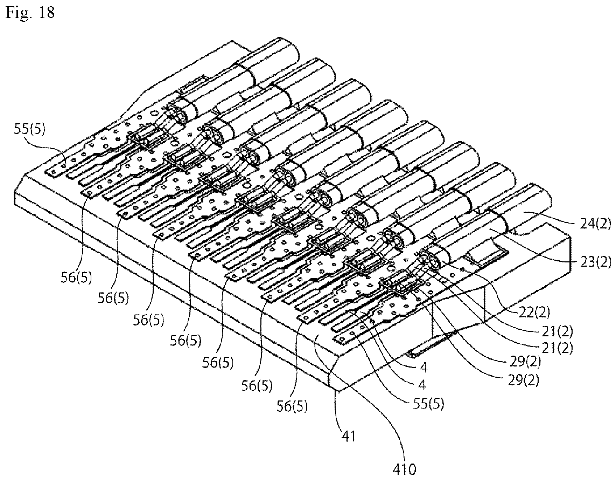

The cable assembly 40C is manufactured through the following stages. As shown in Fig. 18, at the first stage, after the external conductor 23 is soldered to the ground electrode 5 on the surface of the paddle card substrate 41, the exposed portion of the internal conductor 21 of the Twinax cable 2 is soldered to the signal electrode 4 on the surface layer 410 of the paddle card substrate 41, and a solder joining portion 29 is formed.

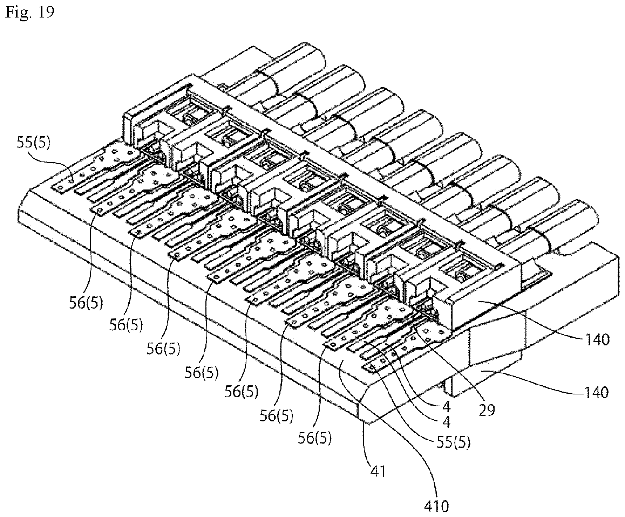

As shown in Fig. 19, at the second stage, the end surface on the -Z side of the plastic member 140 is positioned to be approximately identical to the end surface on the -Z side of the solder joining portion 29, and is fixed on the surface layer 410.

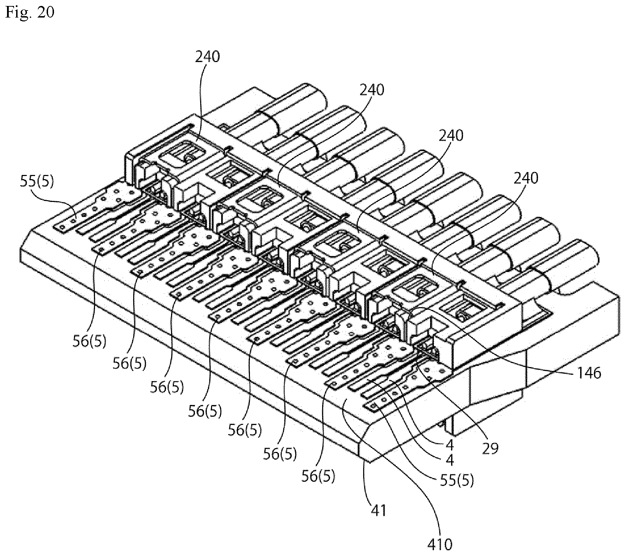

As shown in Fig. 20, at the third stage, the ground cover 240 is inserted from a gap 146 between the adjacent inner frame portions 142 in the plastic member 140 on the surface layer 410 of paddle card substrate 41 into the holes of the extension portions 55 and 56 of the ground electrodes 5, and the press-fit terminal 246 is inserted into the hole of the substrate.

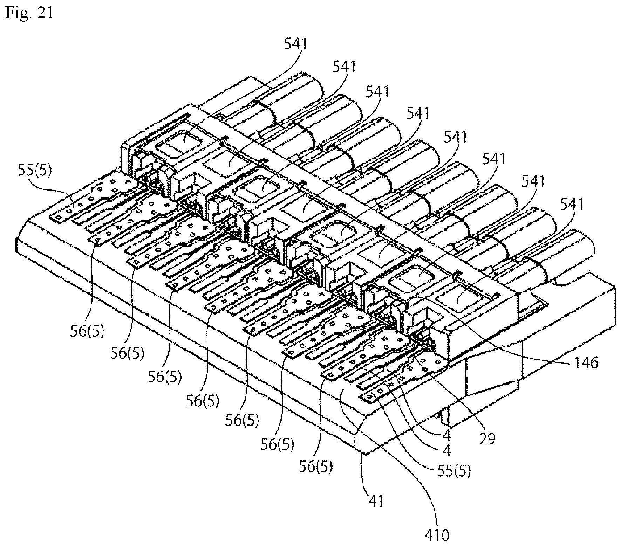

As shown in Fig. 21, at the fourth stage, the potting material 541 is injected from the opening 145 of each inner frame portion 142 in the plastic member 140, and then hardened.

The details of the configuration of the present embodiment are described above. The same effects as those of the above first to third embodiments are obtained according to the present embodiment.

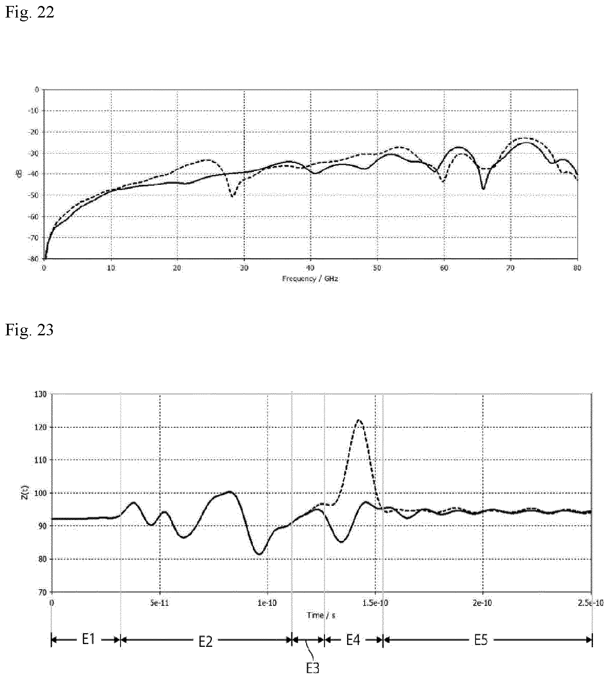

Here, the inventor of the present application performed the following verification to confirm the effects of the present disclosure. First, the inventor of the present application used electromagnetic field analysis software to calculate FEXT in a device connecting the cable assembly 40C at the state of Fig. 20 and the first connector 30 shown in Fig. 1 in two cases: when the ground cover 240 of the cable assembly 40C was in close contact with the ground electrode 5 of the paddle card substrate 41; and when the ground cover 240 was floated by 0.05mm. Fig. 22 is a diagram showing this simulation result. The solid line in Fig. 22 is the FEXT when the ground cover 240 was in close contact with the ground electrode 5 of the paddle card substrate 41. The dashed line in Fig. 22 is the FEXT when the ground cover 240 was floated by 0.05mm from the ground electrode 5 of the paddle card substrate 41.

Referring to Fig. 22, it can be seen that when the ground cover 240 was in close contact with the ground electrode 5 of the paddle card substrate 41, in the bands of 40 to 55 GHz and 68 to 76 GHz, the FEXT is generally 5dB smaller than a case in which the ground cover 240 was floated by 0.05 mm from the surface layer 410 of the paddle card substrate 41.

Second, the inventor of the present disclosure calculated, by a TDR simulator, a TDR waveform in which the cable assembly 40C is used as a DUT, and a TDR waveform in which the cable assembly 40C without the potting material 541 is used as a DUT, respectively. Fig. 23 is a diagram showing this simulation result. In Fig. 23, the solid line is the TDR waveform of the cable assembly 40C, and the dashed line is the TDR waveform of the cable assembly 40C without the potting material 541. In this waveform, section E1 corresponds to the propagation time of the signal of the substrate 20, section E2 corresponds to the propagation time of the signal of the first connector 30, section E3 corresponds to the propagation time of the signal of the solder joining portion 29, section E4 corresponds to the propagation time of the signal of the exposed portion of the internal conductor 21 of the Twinax cable 2, and section E5 corresponds to the propagation time of the signal within the Twinax cable 2.

Referring to Fig. 23, in the TDR waveform of the cable assembly 40C with the potting material 541 removed, the peak impedance in the section E4 has risen to 123 S2, while in the TDR waveform of the cable assembly 40C, the peak impedance in the section E4 has declined to 97 Ω. As shown in Fig. 23, in the cable assembly 40C, the exposed portion of the internal conductor 21 of the Twinax cable 2 is configured so as to be completely covered by the potting material 541, which is thought to contribute to the reduction of the peak impedance in the section E4. When the potting material 541 is injected from the opening 145 of each inner frame portion 142 of the plastic member 140, the potting material can be applied to a fixed range by using the wall of the plastic member to stop the flow. In addition, by mounting the ground cover 240 before injecting the potting material 541, good electrical characteristics can be ensured due to close contact with the ground electrode.

### <Fifth embodiment >

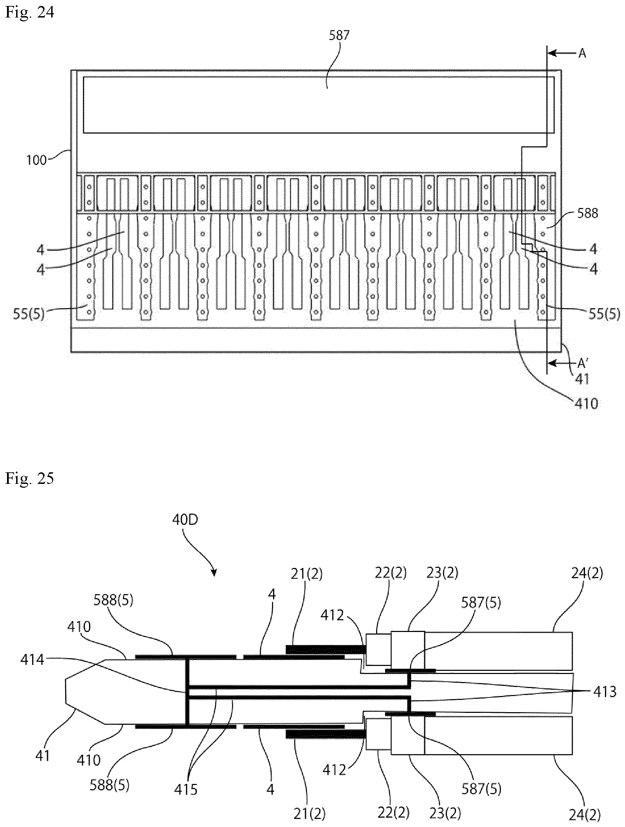

Next, the fifth embodiment of the present embodiment is described. Fig. 24 is a plan view of the paddle card substrate 41 of the fifth embodiment of the present disclosure. Fig. 25 is a cross-sectional view of the fifth embodiment viewed from line A-A' of Fig. 24. In these figures, the same elements as those in the first to fourth embodiments are denoted by the same reference numerals, and a repeated description thereof is omitted.

As shown in Fig. 25, the present embodiment is characterized in that the paddle card substrate 41 has a step.

On the way from the signal electrode 4 to the cable side contact portion 587 of the ground electrode 5 on the surface layer 410 of the paddle card substrate 41, a step 412 with a depth of about the radius of the Twinax cable 2 is formed. The portion on the upper side of the step 412 in the paddle card substrate 41 is thinner than the portion on the lower side of the step 412.

The Twinax cable 2 is positioned in such a manner that the dielectric 22 is contained in the step 412, and is arranged on the surface layer 410. A projection portion of the internal conductor 21 of the Twinax cable 2 is soldered to the signal electrode 4 of the paddle card substrate 41. The external conductor 23 of the Twinax cable 2 is soldered to the cable side contact portion 587 of the ground electrode 5 of the paddle card substrate 41. The surface layer 410 of the paddle card substrate 41 on the left side of the step has the same pattern as the -Z side from the exposed portion (central portion of the E2 in Fig. 17) of the internal conductor 21 of the Twinax cable 2 in Fig. 3. In addition, the ground electrodes 588 on the surface layer of the paddle card substrate 41 are connected to the cable side contact portion 587 of the ground electrode 5 via the inner layer wiring of the paddle card substrate 41 (inner layer through holes 413, 414 and wiring layer 415).

The details of the configuration of the present embodiment are described above. According to this embodiment, there is no need to bend the internal conductor 21 of the Twinax cable 2, and it can be soldered to the signal electrode 4 of the paddle card substrate 41 while remaining straight. Thus, the assembly process can be simplified, and since the positions of the internal conductor exposed from the cable and the signal electrode 4 of the paddle card substrate 41 are almost identical, the area of the air layer around the exposed portion of the internal conductor 21 can be made extremely narrow compared to Fig. 3, and an increase in impedance can be suppressed. With this structure, there is no need to apply resin materials such as hot melt materials, potting materials or the like to the internal conductor 21. Thus, productivity improvements such as low cost and short delivery times can be realized.

The following modifications may be added to this embodiment. The ground cover 240 may be arranged on the ground electrodes 5 arranged at the positions coupled to the contact portions with the first connector 30 on both sides sandwiching the signal electrodes 4 of the paddle card substrate 41 so as to cover the internal conductor 21. With this structure, the ground electrode 5 and the ground cover 240 can be reliably brought into contact with each other by pressing the press-fit terminal 246 of the ground cover 240 into the hole of the ground electrode 5.

In addition, the ground cover 240 covering the internal conductor 21 on the paddle card substrate 41 may be arranged for every channel and arranged alternately with each other on the front and back of the paddle card substrate 41. With this structure, crosstalk suppression can be achieved more effectively.

## Claims

1. A cable assembly (40) arranged between a first connector (30) which is arranged at a position near a control device on a substrate (20) and a second connector (80) which is arranged at a position away from the control device on the substrate (20), the cable assembly (40) comprising:
a cable row (42) in which a plurality of cables (2) each transmitting a differential signal are arranged side by side;
a paddle card substrate (41) provided with signal electrodes (4) to which internal conductors (21) of the plurality of cables (2) are electrically connected and ground electrodes (5) to which external conductors (23) of the plurality of cables (2) are electrically connected; and
a hot melt material (440) arranged on the paddle card substrate (41) so as to cover at least a solder joining portion (29) at a tip of an exposed portion of the internal conductor (21) and the exposed portion of the internal conductor (21).

2. The cable assembly (40) according to claim 1, wherein
a thickness of the hot melt material of the solder joining portion (29) at the tip of the exposed portion of the internal conductor (21) is thinner than a thickness of the hot melt material arranged at the exposed portion of the internal conductor (21).

3. The cable assembly (40) according to claim 1, further comprising a ground cover (240) covering the internal conductor (21) on the paddle card substrate (41),
wherein the hot melt material (440) is arranged on the paddle card substrate (41) so as to cover at least the exposed portion of the internal conductor (21) inside the ground cover (240).

4. The cable assembly (40) according to claim 3, wherein
the hot melt material (440) is arranged on the paddle card substrate (41) so as to cover at least the ground cover (240) and at least the exposed portion of the internal conductor (21) inside the ground cover (240).

5. The cable assembly (40) according to claim 3, wherein
the ground covers (240) are arranged for every channel and arranged alternately with each other on front and back of the paddle card substrate (41).

6. The cable assembly (40) according to claim 5, wherein
the hot melt material (440) is arranged on the paddle card substrate (41) so as to cover at least the ground cover (240) and at least the exposed portion of the internal conductor (21) inside the ground cover (240).
